# EUROPEAN PATENT SPECIFICATION

(11) **EP 4 484 980 B1**
(45) Date of publication and mention of the grant of the patent: **29.04.2026**
(21) Application number: 23771103.1
(22) Date of filing: 15.03.2023
(51) Int. Cl.: G01R 31/367, G01R 31/392, G01R 31/396, G06N 3/08

(54) **BATTERY LIFE PREDICTION APPARATUS AND OPERATING METHOD THEREOF**
VORRICHTUNG ZUR VORHERSAGE DER LEBENSDAUER EINER BATTERIE UND BETRIEBSVERFAHREN DAFÜR
DISPOSITIF DE PRÉDICTION DE DURÉE DE VIE DE BATTERIE ET PROCÉDÉ DE FONCTIONNEMENT ASSOCIÉ

(30) Priority: 18.03.2022 KR 20220034315
(43) Date of publication of application: 01.01.2025
(73) Proprietor: LG Energy Solution, Ltd., Seoul 07335 (KR)
(72) Inventor: KWON, Gi Duk, Daejeon 34122 (KR); JO, Hyeon Deok, Daejeon 34122 (KR); CHAE, Hong Moon, Daejeon 34122 (KR)
(74) Representative: Plasseraud IP
(86) International application number: PCT/KR2023/003492
(87) International publication number: WO 2023/177224

(56) References cited:
- KR-A- 20160 017 416
- KR-A- 20160 030 643
- KR-A- 20170 020 072
- KR-A- 20180 102 882
- KR-A- 20190 115 937
- US-A1- 2016 209 472
- US-A1- 2021 373 082
- HONG JICHAO ET AL: "Fault prognosis of battery system based on accurate voltage abnormity prognosis using long short-term memory neural networks", APPLIED ENERGY, ELSEVIER SCIENCE PUBLISHERS, GB, vol. 251, 25 May 2019 (2019-05-25), XP085784383, ISSN: 0306-2619, [retrieved on 20190525], DOI: 10.1016/J.APENERGY.2019.113381
- VENUGOPAL PRAKASH ET AL: "State-of-Health Estimation of Li-ion Batteries in Electric Vehicle Using IndRNN under Variable Load Condition", ENERGIES, vol. 12, no. 22, 14 November 2019 (2019-11-14), pages 4338, XP055772273, DOI: 10.3390/en12224338
- KARMAWIJAYA MUCHAMAD IMAN ET AL: "Development of Big Data Analytics Platform for Electric Vehicle Battery Management System", 2019 6TH INTERNATIONAL CONFERENCE ON ELECTRIC VEHICULAR TECHNOLOGY (ICEVT), IEEE, 18 November 2019 (2019-11-18), pages 151 - 155, XP033714989, DOI: 10.1109/ICEVT48285.2019.8994013

## Description

### [TECHNICAL FIELD]

### CROSS-REFERENCE TO RELATED APPLICATIONS

This application claims priority to and the benefit of Korean Patent Application No. 10-2022-0034315 filed in the Korean Intellectual Property Office on March 18, 2022.

### TECHNICAL FIELD

Embodiments disclosed herein relate to a battery life prediction apparatus and an operating method thereof.

### [BACKGROUND ART]

An energy storage system (ESS) is a system that stores electrical energy and manages the same for use when needed, and in general, an energy storage system installed in a power plant driving a large-scale energy grid or a building with high energy consumption includes hundreds to thousands of battery cells. To predict and manage a time to replace a battery of the ESS from a user's viewpoint and guarantee quality from a producer's viewpoint, it is important to accurately predict the remaining life of the battery.

A conventional battery life prediction method mainly uses cell-based modeling, and uses information (current, voltage, temperature, etc.) of individual battery cells measured by sensors and a corresponding estimated life table to predict a remaining life. This method may relatively accurately predict a life for a single usage pattern, but the accuracy of prediction may be degraded for an input of a complex usage pattern. Moreover, a life needs to be recalculated whenever the usage pattern changes, taking a long time, and when a degradation model with a reference SOH set to100% is applied, the life of the battery has already decreased at the time of change of the usage pattern, further increasing a prediction error. Prior art US2016/209472 teaches how vehicle battery remaining useful life is influenced by driving style, battery charging patterns, and incorporates this information in various ways, including machine learning.

### [DISCLOSURE]

### [TECHNICAL PROBLEM]

Embodiments disclosed herein aim to provide an apparatus and method for more quickly and precisely predicting a remaining life of a battery for an input of a complex battery usage pattern.

Technical problems of the embodiments disclosed herein are not limited to the above-described technical problems, and other unmentioned technical problems would be clearly understood by one of ordinary skill in the art from the following description.

### [TECHNICAL SOLUTION]

A battery life prediction apparatus according to an embodiment includes a data generation unit configured to generate remaining life data corresponding to each of a plurality of usage pattern information regarding a battery and a battery life prediction unit configured to classify a plurality of usage patterns into at least one class by using a trained artificial neural network model, determine a representative usage pattern among usage patterns belonging to each class, and predict a life of the battery based on remaining life data corresponding to the representative usage pattern.

The battery life prediction apparatus according to an embodiment may further include an artificial neural network model training unit configured to train the artificial neural network model to classify an input usage pattern as the at least one class.

In the battery life prediction apparatus according to an embodiment, the artificial neural network model may calculate a similarity between the input usage pattern and the representative usage pattern and determine a class of the usage pattern based on the similarity.

In the battery life prediction apparatus according to an embodiment, the artificial neural network model may calculate the similarity based on a battery life reduction rate of each of the input usage pattern and the representative usage pattern in a specific period.

In the battery life prediction apparatus according to an embodiment, the battery life prediction unit may be further configured to determine, as a representative usage pattern, a usage pattern that has a greatest impact on a remaining life of the battery, among a plurality of usage patterns belonging to each class.

In the battery life prediction apparatus according to an embodiment, the battery life prediction unit may be further configured to predict the life of the battery based on the remaining life data corresponding to a representative usage pattern of a class to which an actual usage pattern of the battery belongs, instead of a remaining life data corresponding to the actual usage pattern.

In the battery life prediction apparatus according to an embodiment, the battery life prediction unit may be further configured to convert first data indicating a remaining life of the representative usage pattern with respect to a usage time into second data indicating a time required for reaching the remaining life, and to calculate a remaining life with respect to a change of the usage pattern of the battery based on second data of a representative usage pattern of each of a class to which a usage pattern before the change belongs and a class to which a usage pattern after the change belongs when the usage pattern of the battery changes.

In the battery life prediction apparatus according to an embodiment, the usage pattern information may include at least one of an accumulated discharge energy, a state of charge (SoC), a depth of discharge (DoD), a C-rate, and a CP-rate of the battery.

An operating method of a battery life prediction apparatus according to an embodiment includes generating remaining life data corresponding to each of a plurality of usage pattern information regarding a battery, classifying a plurality of usage patterns into at least one class by using a trained artificial neural network model, determining a representative usage pattern among usage patterns belonging to each class, and predicting a life of the battery based on remaining life data corresponding to the representative usage pattern.

The operating method according to an embodiment may further include training the artificial neural network model to classify an input usage pattern as the at least one class.

In the operating method according to an embodiment, the artificial neural network model may calculate a similarity between the input usage pattern and the representative usage pattern and determine a class of the usage pattern based on the similarity.

In the operating method according to an embodiment, the artificial neural network model may calculate the similarity based on a battery life reduction rate of each of the input usage pattern and the representative usage pattern in a specific period.

In the operating method according to an embodiment, the determining of the representative usage pattern may include determining, as a representative usage pattern, a usage pattern that has a greatest impact on a remaining life of the battery, among a plurality of usage patterns belonging to each class.

In the operating method according to an embodiment, the predicting of the life of the battery may include predicting the life of the battery based on the remaining life data corresponding to a representative usage pattern of a class to which an actual usage pattern of the battery belongs, instead of a remaining life data corresponding to the actual usage pattern.

In the operating method according to an embodiment, the predicting of the life of the battery may include converting first data indicating a remaining life of the representative usage pattern with respect to a usage time into second data indicating a time required for reaching the remaining life and calculating a remaining life with respect to a change of the usage pattern of the battery based on second data of a representative usage pattern of each of a class to which a usage pattern before the change belongs and a class to which a usage pattern after the change belongs when the usage pattern of the battery changes.

In the operating method according to an embodiment, the usage pattern information may include at least one of an accumulated discharge energy, a state of charge (SoC), a depth of discharge (DoD), a C-rate, and a CP-rate of the battery.

### [ADVANTAGEOUS EFFECTS]

According to an embodiment, an apparatus and method for more quickly and precisely predicting a remaining life of a battery for an input of a complex battery usage pattern may be provided.

According to the proposed apparatus, a plurality of usage patterns may be classified by similarity by using an artificial neural network model, and a life reduction rate of a representative usage pattern of each group instead of an actual usage pattern may be applied, thereby reducing a time required for life prediction. Furthermore, unlike an existing method in which the accuracy of life prediction decreases as the battery degrades, the life may be accurately predicted even when the usage pattern changes in the battery with degradation having progressed.

In addition, various effects identified directly or indirectly through this document may be provided.

### [DESCRIPTION OF DRAWINGS]

To more clearly describe the technical solutions of the embodiments disclosed herein or the prior art, drawings required in the description of the embodiments are briefly introduced below. It should be understood that the following drawings are for the purpose of explaining the embodiments of the present specification and not for the purpose of limitation. In addition, representation of some elements in the drawings may be exaggerated or omitted for clarity of description.
FIG. 1 is a block diagram showing a structure of a battery life prediction apparatus according to an embodiment.
FIG. 2 is a graph showing comparison between a result of applying a battery life prediction method according to the prior art and a result of applying a life prediction method according to an embodiment.
FIG. 3 is a graph showing a result of verifying a precision of class classification for an input usage pattern using an artificial neural network model according to an embodiment.
FIG. 4 is a graph showing a result of verifying precision of battery life prediction using an artificial neural network model according to an embodiment.
FIGS. 5A and 5B show tables for predicting a life of a battery by using battery usage pattern class-specific usage time-remaining life data.
FIG. 6 is a flowchart of an operating method of a battery life prediction apparatus according to an embodiment.
FIG. 7 shows a computing system that executes a battery life prediction method according to an embodiment.

### [MODE FOR INVENTION]

Hereinafter, embodiments disclosed herein will be described in detail through exemplary drawings. In adding reference numerals to components of each drawing, it should be noted that the same components have the same numerals as much as possible even though they are displayed on different drawings. Moreover, in describing the embodiments disclosed herein, when it is determined that a detailed description of a related known configuration or function interferes with understanding of the embodiment disclosed herein, the detailed description thereof will be omitted.

Although terms used in the specification are selected with general terms popularly used at present under the consideration of functions, the terms may vary according to the intention of those of ordinary skill in the art, judicial precedents, or introduction of new technology. In addition, in a specific case, the applicant voluntarily may select terms, and in this case, the meaning of the terms may be disclosed in a corresponding description part of the specification. Thus, the terms used herein should be interpreted not by the simple names of the terms but by the meaning of the terms and the contents throughout the present document. In addition, terms used herein are used for only describing a specific exemplary embodiment and may not have an intention to limit the scope of other exemplary embodiments. It is to be understood that the singular forms include plural references unless the context clearly dictates otherwise.

Hereinafter, exemplary embodiments of a battery life prediction apparatus and an operating method thereof using the same will be described with reference to drawings.

Components shown in the block diagram are classified according to their respective functions and roles, and each block does not necessarily have to be implemented as independent hardware or software. For example, separate components may be actually implemented as one device or program, or one component may be implemented as a combination of several devices and programs. In addition, expressions such as "first", "second", or the like herein are used to distinguish components from each other, and do not mean a rank or order among the components.

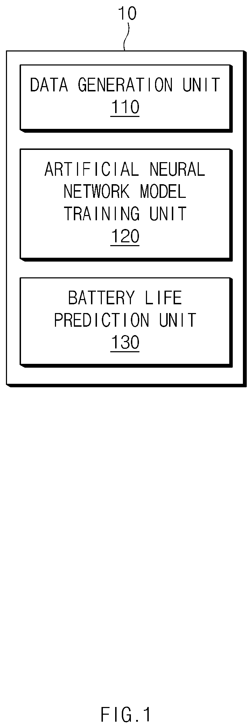

FIG. 1 is a block diagram showing a structure of a battery life prediction apparatus according to an embodiment.

Referring to FIG. 1, a battery life prediction apparatus 10 may include a data generation unit 110, an artificial neural network model training unit 120, and a battery life prediction unit 130.

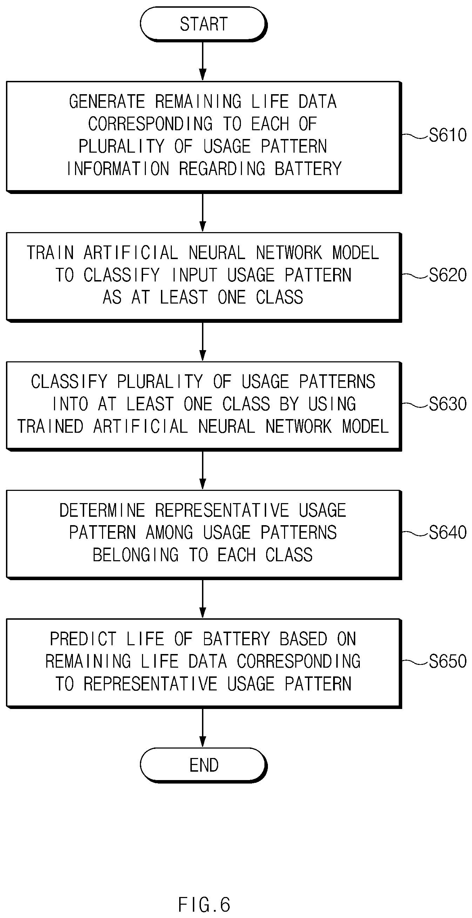

The data generation unit 110 may be configured to generate remaining life data corresponding to each of a plurality of usage pattern information regarding a battery(S610 in FIG. 6). The remaining life data may include remaining life information after usage of a battery of the same specification in a specific usage pattern for a predetermined time (e.g., 24 hours), and may be expressed as a state of health (SoH) value.

According to an embodiment, to generate usage pattern-specific remaining life data, the data generation unit 110 may perform an operation of calculating a life factor (e.g., an SoC, a CP-rate, a module temperature, etc.) that affects battery life reduction and an operation of calculating a proper range for each life factor (e.g., an SoC of 1 to 96, a CP rate of 0.1 to 0.5, a module temperature of 25 to 40 °C, the number of cycles of 1 to 4, etc.) to normalize data of different types.

For example, the data generation unit 110 may obtain battery usage pattern information for last 15 years and generate a table in which 20 thousands or more usage patterns and a remaining life (SoH) corresponding to each usage pattern are mapped according to a predetermined criterion. According to an embodiment, the usage pattern information may include at least one of an accumulated discharge energy, a state of charge (SoC), a depth of discharge (DoD), a C-rate, and a CP-rate of the battery.

The artificial neural network model training unit 120 may train an artificial neural network model to classify an input usage pattern as at least one class according to a preset criterion(S620 of FIG. 6). According to an embodiment, a deep feed-forward network (DFN) algorithm that is a forward neural network model may be used as the artificial neural network model, without being limited thereto. The artificial neural network model training unit 120 may learn data classified as each class based on usage pattern information, and the battery life prediction unit 130 may predict a remaining life at a particular time with respect to change of a usage pattern by using the trained artificial neural network model.

According to an embodiment, the artificial neural network model may calculate a similarity between an input usage pattern and a representative usage pattern and determine a class of the usage pattern based on the similarity. The similarity between the usage patterns may be calculated based on a battery life reduction rate in a specific period. For example, to determine the class of the input usage pattern, a class to which a representative usage pattern having the closest life reduction rate (or a remaining life after usage) belongs may be selected based on a result of analyzing battery usage information of a specific year. That is, unlike an existing method in which a life is predicted based on sensing information of a battery and a degradation model, the remaining life may be predicted by analyzing the similarity between the usage patterns based on massive data and applying a life reduction rate of the most similar representative pattern.

According to an embodiment, the artificial neural network model training unit 120 may perform an operation of dividing a data set generated for machine learning into a training unit, verifying unit, and a testing unit, an operation of estimating a parameter having the highest model prediction accuracy according to a preset hyper parameter criterion, an operation of extracting a parameter that yields the highest model accuracy index, and an operation of applying the calculated parameter to the artificial neural network model.

The battery life prediction unit 130 may classify a plurality of usage patterns into at least one class by using the trained artificial neural network model(S630 of FIG. 6), determine a representative usage pattern among usage patterns belong to the respective classes(S640 of FIG. 6), and predict the life of the battery based on remaining life data corresponding to the representative usage pattern(S650 of FIG. 6).

As described above, the artificial neural network model (e.g., the DFN model) may calculate a similarity between usage patterns by using a life reduction rate in a specific period, and classify input usage patterns into a plurality of classes (e.g., class 1 to class 30) based on the similarity.

Once a class is determined for each usage pattern, the battery life prediction unit 130 may determine, as a representative usage pattern, a usage pattern that has the greatest impact on the remaining life of the battery, among a plurality of usage patterns belong to each class. For example, assuming that usage patterns 1 to 5 belong to a class 1 and usage patterns 6 to 10 belong to a class 2, then the usage pattern having the greatest battery life reduction rate among the usage patterns 1 to 5 may be determined as a representative usage pattern of the class 1 and the usage pattern having the greatest battery life reduction rate among the usage patterns 6 to 10 may be determined as a representative usage pattern of the class 2. The battery life reduction rate of each usage pattern may be obtained from a usage pattern-specific remaining life data table generated by the data generation unit 110.

Once a representative usage pattern is determined for each class, the battery life prediction unit 130 may predict the life of the battery based on remaining life data corresponding to a representative usage pattern of a class to which an actual usage pattern belongs, instead of based on the remaining life data corresponding to the actual usage pattern. For example, assuming that usage patterns 1 to 5 belong to the class 1 and a representative usage pattern of the class is the usage pattern 2, then the life of the battery may be predicted by applying a life reduction rate of the representative usage pattern 2 instead of the input actual usage pattern 1 of the battery.

with the diversification of the use pattern of the ESS battery, when applying a complex usage pattern one by one, calculation becomes complicated and takes a lot of time because a remaining life corresponding to tens of thousands of usage patterns have to be calculated. By applying a reduction rate of a representative usage pattern of a belonging class, instead of an actual usage pattern like in an embodiment, a life may be predicted more quickly.

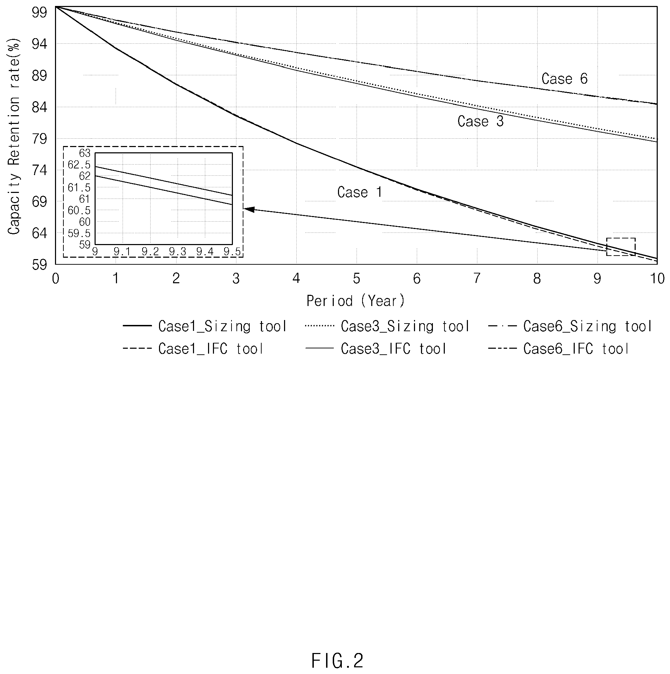

FIG. 2 is a graph showing comparison between a result of applying a battery life prediction method according to the prior art and a result of applying a life prediction method according to an embodiment.

In simulation for result comparison, for three cases Case 1, Case 3, and Case 6, each including one or more usage patterns, a capacity reduction rate with respect to a battery usage time is calculated using a conventional degradation model-based life prediction method (sizing tool) and a life prediction method (IFC tool) according to an embodiment. Table 1 provided below shows an error between a degradation rate Rs calculated using a conventional life prediction method and a degradation rate Rf calculated using a life prediction method according to an embodiment over time.

**[Table 1]**

| Case | | Period (Year) | | | | | | | | | | |
|---|---|---|---|---|---|---|---|---|---|---|---|---|
| | | 0 | 1 | 2 | 3 | 4 | 5 | 6 | 7 | 8 | 9 | 10 |
| Δ(Rs-Rf) | Case 1 | 0 | -0.14 | -0.1 | -0.04 | 4.01 E-12 | 0.05 | 0.14 | 0.26 | 0.3 | 0.41 | 0.38 |
| | Case 3 | 0 | 0.08 | 0.18 | 0.22 | 0.3 | 0.36 | 0.44 | 0.45 | 0.49 | 0.45 | 0.47 |
| | Case 6 | 0 | -0.12 | -0.12 | -0.1 | -0.05 | 4.59 E-12 | 0.01 | -0.03 | 0.02 | 0.02 | 0.1 |

Referring to the graph of FIG. 2 and Table 1, it may be seen that for all of the cases Case 1, Case 3, and Case 6, overall life prediction results are almost the same though an error slightly increases as a period of usage has elapsed. This result shows that a prediction model of an embodiment using class classification and a representative usage pattern has no significant difference in prediction result in spite of having a higher calculation speed than that of the conventional art. As more complicated and more usage patterns are applied, the effect of time cost reduction according to the present art further increases.

According to an example, the life of the battery may be predicted based on the remaining life data corresponding to the representative usage pattern of the class to which the actual usage pattern belongs, instead of the remaining life data corresponding to the actual usage pattern of the battery. For example, assuming that usage patterns 1 to 5 belong to the class 1 and a representative usage pattern of the class is the usage pattern 2, then the life of the battery may be predicted by applying a life reduction rate of the representative usage pattern 2 instead of the input actual usage pattern 1 of the battery.

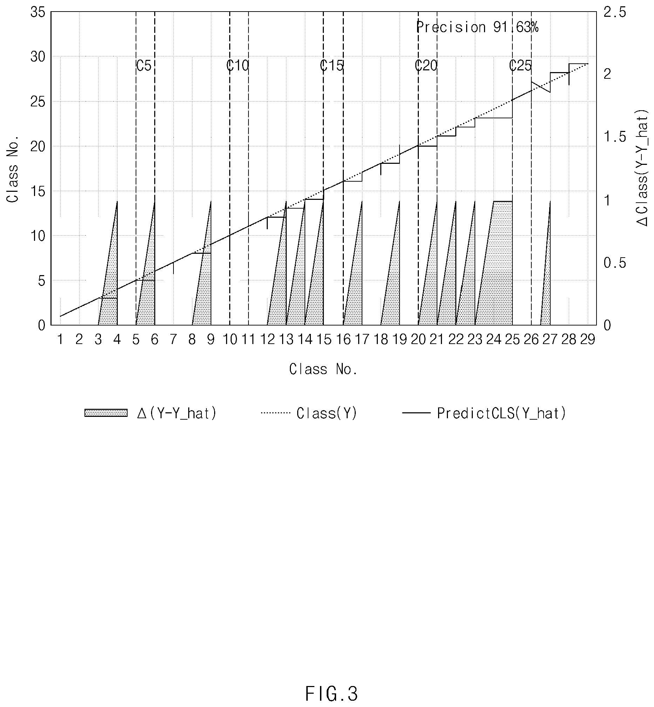

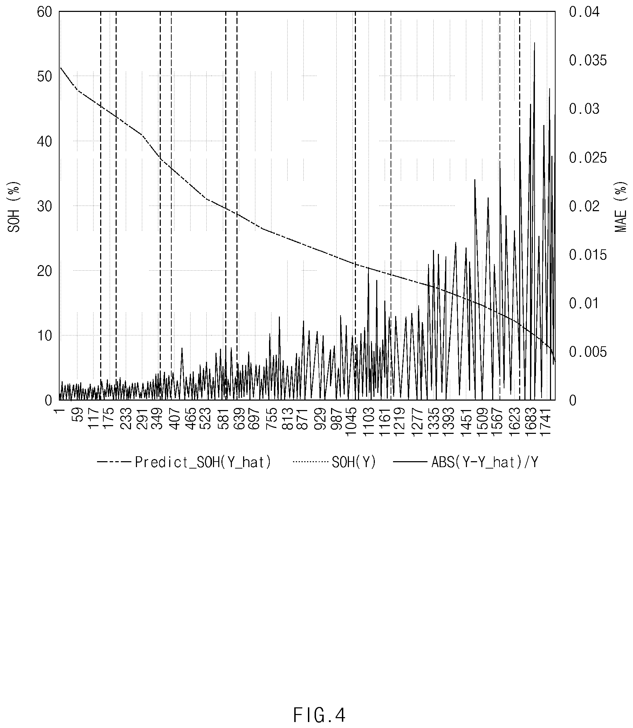

As such, by applying a reduction rate of a representative usage pattern of a belonging class, instead of an actual usage pattern like in an embodiment, a life may be predicted more quickly. Comparison between life prediction results according to the method of the embodiment and the method of the conventional art is described above with reference to FIGS. 2 to 4.

According to an embodiment, operation S650 of predicting the life of the battery may include operation of converting first data indicating a remaining life with respect to a usage time of a representative usage pattern into second data indicating a time required for reaching the remaining life, and an operation of calculating a remaining life with respect to a change of a usage pattern of the battery based on second data of a representative usage pattern of each of a class to which a usage pattern before the change belongs and a class to which a usage pattern after the change belongs when the usage pattern of the battery changes.

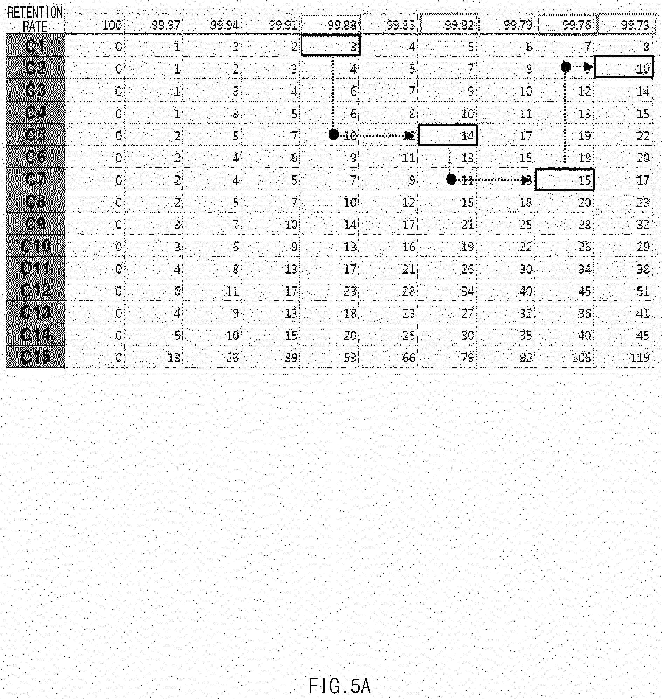

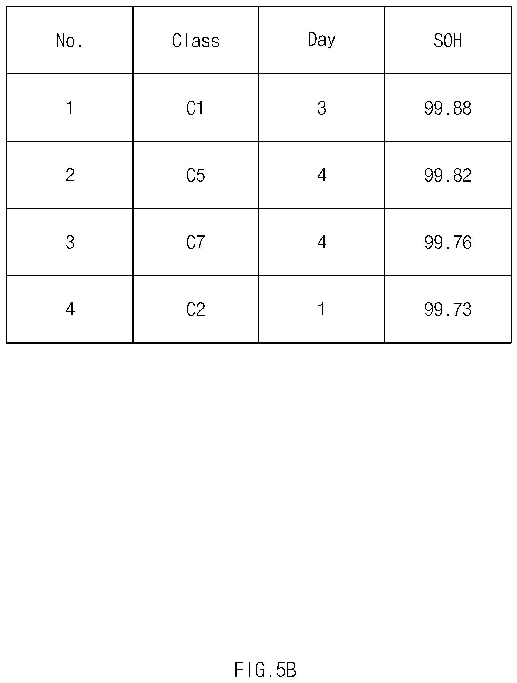

According to the current embodiment, unlike the conventional art where accurate prediction is possible only in an initial state where the battery is not degraded, it is possible to predict a more accurate degradation curve when the usage pattern changes even if degradation is already in progress. An exemplary method for predicting the life of the battery by using class-specific usage time-remaining life data is described above with reference to FIG. 5.

The operating method of the battery life prediction apparatus according to the above-described embodiment may be implemented as an application or in the form of a program instruction that may be executed through various computer components, and may be recorded on a computer-readable recording medium. The computer-readable recording medium may include a program instruction, a data file, a data structure and the like solely or in a combined manner.

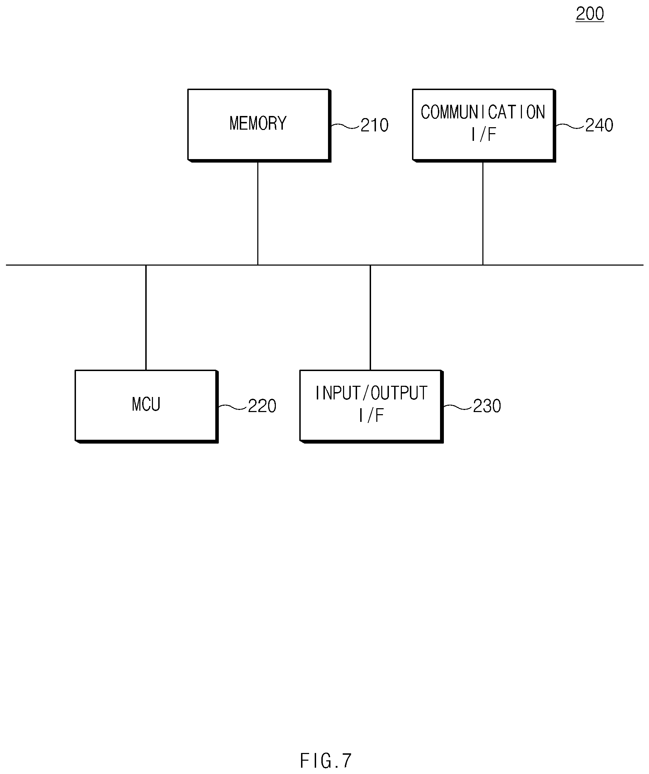

FIG. 7 shows a computing system that executes a battery life prediction method according to an embodiment.

Referring to FIG. 7, a computing device 200 according to an embodiment disclosed herein may include a microcontroller unit (MCU) 220, a memory 210, an input/output interface (I/F) 230, and a communication I/F 240.

The MCU 220 may be a processor that executes various programs stored in the memory 210, predicts a remaining life of a battery cell according to a usage pattern through these programs, and executes functions of the battery life prediction apparatus 10 described with reference to FIGS. 1 to 5 or executes the operating method of the battery life prediction apparatus described with reference to FIG. 6.

The memory 210 may store various programs related to life prediction of the battery (e.g., a usage pattern-remaining life data generation program, an artificial neural network model training program, a battery life prediction program, etc.). The memory 210 may also store various data generated by the data generation unit 110.

The memory 210 may be provided in plural, depending on a need. The memory 210 may be a volatile or nonvolatile memory. For the memory 210 as the volatile memory, random access memory (RAM), dynamic RAM (DRAM), static RAM (SRAM), etc., may be used. For the memory 210 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 210 are merely examples and are not limited thereto.

The input/output I/F 230 may provide an interface for transmitting and receiving data by connecting an input device (not shown) such as a keyboard, a mouse, a touch panel, etc., and an output device such as a display (not shown), etc., with the MCU 220.

The communication I/F 240, which is a component capable of transmitting and receiving various data to and from a server, may be various types of devices capable of supporting wired or wireless communication. For example, a program for remaining life prediction or artificial neural network training of the battery or various data, etc., may be transmitted and received to and from a separately provided external server through the communication I/F 240.

As such, the battery management method according to an embodiment disclosed herein may be recorded in the memory 210 and executed by the MCU 220.

According to the foregoing embodiments, a plurality of usage patterns may be classified by similarity by using an artificial neural network model, and a life reduction rate of a representative usage pattern of each group instead of an actual usage pattern is applied, thereby reducing a time required for life prediction. Furthermore, unlike an existing method in which the accuracy of life prediction decreases as the battery degrades, the life may be accurately predicted even when the usage pattern changes in the battery with degradation having progressed.

So far, all components constituting the embodiment have been described as being combined or combined to operate as one, but it is not necessarily limited to this embodiment, and within the scope of the purpose, all components may be selectively combined with one or more components to operate. Moreover, terms such as "include", "constitute" or "have" described above may mean that the corresponding component may be inherent unless otherwise stated, and thus should be construed as further including other components rather than excluding other components.

The above description is merely illustrative of the technical idea disclosed herein, and various modifications and variations will be possible without departing from the essential characteristics of the embodiments disclosed herein by those of ordinary skill in the art to which the embodiments disclosed herein pertains.

## Claims

1. A battery life prediction apparatus (10) comprising:
a data generation unit (110) configured to generate remaining life data corresponding to each of a plurality of usage pattern information regarding a battery; and
a battery life prediction unit (130) configured to classify a plurality of usage patterns into at least one class by using a trained (120) artificial neural network model, determine a representative usage pattern among usage patterns belonging to each class, and predict a life of the battery based on remaining life data corresponding to the representative usage pattern.

2. The battery life prediction apparatus of claim 1, further comprising an artificial neural network model training unit configured to train the artificial neural network model to classify an input usage pattern as the at least one class.

3. The battery life prediction apparatus of claim 2, wherein the artificial neural network model calculates a similarity between the input usage pattern and the representative usage pattern and determines a class of the usage pattern based on the similarity.

4. The battery life prediction apparatus of claim 3, wherein the artificial neural network model calculates the similarity based on a battery life reduction rate of each of the input usage pattern and the representative usage pattern in a specific period.

5. The battery life prediction apparatus of claim 1, wherein the battery life prediction unit is further configured to determine, as a representative usage pattern, a usage pattern that has a greatest impact on a remaining life of the battery, among a plurality of usage patterns belonging to each class.

6. The battery life prediction apparatus of claim 5, wherein the battery life prediction unit is further configured to predict the life of the battery based on the remaining life data corresponding to a representative usage pattern of a class to which an actual usage pattern of the battery belongs, instead of a remaining life data corresponding to the actual usage pattern.

7. The battery life prediction apparatus of claim 6, wherein the battery life prediction unit is further configured to convert first data indicating a remaining life of the representative usage pattern with respect to a usage time into second data indicating a time required for reaching the remaining life, and to calculate a remaining life with respect to a change of the usage pattern of the battery based on second data of a representative usage pattern of each of a class to which a usage pattern before the change belongs and a class to which a usage pattern after the change belongs when the usage pattern of the battery changes.

8. The battery life prediction apparatus of claim 1, wherein the usage pattern information comprises at least one of an accumulated discharge energy, a state of charge (SoC), a depth of discharge (DoD), a C-rate, and a CP-rate of the battery.

9. An operating method of a battery life prediction apparatus, the operating method comprising:
generating (S610) remaining life data corresponding to each of a plurality of usage pattern information regarding a battery;
classifying (S630) a plurality of usage patterns into at least one class by using a trained (S620) artificial neural network model;
determining (S640) a representative usage pattern among usage patterns belonging to each class; and
predicting (S650) a life of the battery based on remaining life data corresponding to the representative usage pattern.

10. The operating method of claim 9, further comprising training the artificial neural network model to classify an input usage pattern as the at least one class.

11. The operating method of claim 10, wherein the artificial neural network model calculates a similarity between the input usage pattern and the representative usage pattern and determines a class of the usage pattern based on the similarity.

12. The operating method of claim 11, wherein the artificial neural network model calculates the similarity based on a battery life reduction rate of each of the input usage pattern and the representative usage pattern in a specific period.

13. The operating method of claim 9, wherein the determining of the representative usage pattern comprises determining, as a representative usage pattern, a usage pattern that has a greatest impact on a remaining life of the battery, among a plurality of usage patterns belonging to each class.

14. The operating method of claim 13, wherein the predicting of the life of the battery comprises predicting the life of the battery based on the remaining life data corresponding to a representative usage pattern of a class to which an actual usage pattern of the battery belongs, instead of a remaining life data corresponding to the actual usage pattern.

15. The operating method of claim 13, wherein the predicting of the life of the battery comprises:
converting first data indicating a remaining life of the representative usage pattern with respect to a usage time into second data indicating a time required for reaching the remaining life; and
calculating a remaining life with respect to a change of the usage pattern of the battery based on second data of a representative usage pattern of each of a class to which a usage pattern before the change belongs and a class to which a usage pattern after the change belongs when the usage pattern of the battery changes.

## Patentansprüche

1. Batterielebensdauervorhersagevorrichtung (10), umfassend:
eine Datengenerierungseinheit (110), welche dazu eingerichtet ist, Daten einer verbleibenden Lebensdauer zu generieren, welche jeder aus einer Mehrzahl von Informationen eines Verwendungsmusters bezüglich einer Batterie entsprechen; und
eine Batterielebensdauervorhersageeinheit (130), welche dazu eingerichtet ist, eine Mehrzahl von Verwendungsmustern in wenigstens eine Klasse zu klassifizieren durch ein Verwenden eines trainierten (120) künstlichen neuronalen Netzwerkmodells, ein repräsentatives Verwendungsmuster unter Verwendungsmustern zu bestimmen, welche jeder Klasse angehören, und eine Lebensdauer der Batterie basierend auf Daten einer verbleibenden Lebensdauer vorherzusagen, welche dem repräsentativen Verwendungsmuster entsprechen.

2. Batterielebensdauervorhersagevorrichtung nach Anspruch 1, ferner umfassend eine Trainingseinheit eines künstlichen neuronalen Netzwerkmodells, welche dazu eingerichtet ist, das künstliche neuronale Netzwerkmodell zu trainieren, um ein Eingabe-Verwendungsmuster als die wenigstens eine Klasse zu klassifizieren.

3. Batterielebensdauervorhersagevorrichtung nach Anspruch 2, wobei das künstliche neuronale Netzwerkmodell eine Ähnlichkeit zwischen dem Eingabe-Verwendungsmuster und dem repräsentativen Verwendungsmuster berechnet und eine Klasse des Verwendungsmusters basierend auf der Ähnlichkeit bestimmt.

4. Batterielebensdauervorhersagevorrichtung nach Anspruch 3, wobei das künstliche neuronale Netzwerkmodell die Ähnlichkeit basierend auf einer Batterielebensdauerreduktionsrate von jedem von dem Eingabe-Verwendungsmuster und dem repräsentativen Verwendungsmuster in einer spezifischen Periode berechnet.

5. Batterielebensdauervorhersagevorrichtung nach Anspruch 1, wobei die Batterielebensdauervorhersageeinheit ferner dazu eingerichtet ist, ein Verwendungsmuster, welches einen größten Einfluss auf eine verbleibende Lebensdauer der Batterie aufweist, unter einer Mehrzahl von Verwendungsmustern, welche zu jeder Klasse gehören, als ein repräsentatives Verwendungsmuster zu bestimmen.

6. Batterielebensdauervorhersagevorrichtung nach Anspruch 5, wobei die Batterielebensdauervorhersageeinheit ferner dazu eingerichtet ist, die Lebensdauer der Batterie basierend auf den Daten einer verbleibenden Lebensdauer, welche einem repräsentativen Verwendungsmuster einer Klasse entsprechen, zu welcher ein tatsächliches Verwendungsmuster der Batterie gehört, anstelle von Daten einer verbleibenden Lebensdauer vorherzusagen, welche dem tatsächlichen Verwendungsmuster entsprechen.

7. Batterielebensdauervorhersagevorrichtung nach Anspruch 6, wobei die Batterielebensdauervorhersageeinheit ferner dazu eingerichtet ist, erste Daten, welche eine verbleibende Lebensdauer des repräsentativen Verwendungsmusters in Bezug auf eine Verwendungszeit indizieren, in zweite Daten zu konvertieren, welche eine Zeit indizieren, welche erforderlich ist, um die verbleibende Lebensdauer zu erreichen, und eine verbleibende Lebensdauer in Bezug auf eine Änderung des Verwendungsmusters der Batterie basierend auf zweiten Daten eines repräsentativen Verwendungsmusters von jeder einer Klasse, zu welcher ein Verwendungsmuster vor der Änderung gehört, und einer Klasse zu berechnen, zu welcher ein Verwendungsmuster nach der Änderung gehört, wenn sich das Verwendungsmuster der Batterie ändert.

8. Batterielebensdauervorhersagevorrichtung nach Anspruch 1, wobei die Informationen eines Verwendungsmusters wenigstens eines umfassen aus einer akkumulierten Entladeenergie, einem Ladezustand (SoC), einer Entladetiefe (DoD), einer C-Rate und einer CP-Rate der Batterie.

9. Betriebsverfahren für eine Batterielebensdauervorhersagevorrichtung, wobei das Betriebsverfahren umfasst:
Generieren (S610) von Daten einer verbleibenden Lebensdauer, welche jeder einer Mehrzahl von Informationen eines Verwendungsmusters bezüglich einer Batterie entsprechen;
Klassifizieren (S630) einer Mehrzahl von Verwendungsmustern in wenigstens eine Klasse durch ein Verwenden eines trainierten (S620) künstlichen neuronalen Netzwerkmodells;
Bestimmen (S640) eines repräsentativen Verwendungsmusters unter Verwendungsmustern, welche jeder Klasse angehören; und
Vorhersagen (S650) einer Lebensdauer der Batterie basierend auf Daten einer verbleibenden Lebensdauer, welche dem repräsentativen Verwendungsmuster entsprechen.

10. Betriebsverfahren nach Anspruch 9, ferner umfassend ein Trainieren des künstlichen neuronalen Netzwerkmodells, um ein Eingabe-Verwendungsmuster als die wenigstens eine Klasse zu klassifizieren.

11. Betriebsverfahren nach Anspruch 10, wobei das künstliche neuronale Netzwerkmodell eine Ähnlichkeit zwischen dem Eingabe-Verwendungsmuster und dem repräsentativen Verwendungsmuster berechnet und eine Klasse des Verwendungsmusters basierend auf der Ähnlichkeit bestimmt.

12. Betriebsverfahren nach Anspruch 11, wobei das künstliche neuronale Netzwerkmodell die Ähnlichkeit basierend auf einer Batterielebensdauerreduktionsrate von jedem der Eingabe-Verwendungsmuster und dem repräsentativen Verwendungsmuster in einer spezifischen Periode berechnet.

13. Betriebsverfahren nach Anspruch 9, wobei das Bestimmen des repräsentativen Verwendungsmusters ein Bestimmen eines Verwendungsmusters, welches einen größten Einfluss auf eine verbleibende Lebensdauer der Batterie aufweist, unter einer Mehrzahl von Verwendungsmustern, welche jeder Klasse angehören, als ein repräsentatives Verwendungsmuster umfasst.

14. Betriebsverfahren nach Anspruch 13, wobei das Vorhersagen der Lebensdauer der Batterie ein Vorhersagen der Lebensdauer der Batterie basierend auf den Daten einer verbleibenden Lebensdauer umfasst, welche einem repräsentativen Verwendungsmuster einer Klasse entsprechen, welcher ein tatsächliches Verwendungsmuster der Batterie angehört, anstelle von Daten einer verbleibenden Lebensdauer, welche dem tatsächlichen Verwendungsmuster entsprechen.

15. Betriebsverfahren nach Anspruch 13, wobei das Vorhersagen der Lebensdauer der Batterie umfasst:
Konvertieren erster Daten, welche eine verbleibende Lebensdauer des repräsentativen Verwendungsmusters in Bezug auf eine Verwendungszeit indizieren, in zweite Daten, welche eine Zeit indizieren, welche erforderlich ist, um die verbleibende Lebensdauer zu erreichen; und
Berechnen einer verbleibenden Lebensdauer in Bezug auf eine Änderung des Verwendungsmusters der Batterie basierend auf zweiten Daten eines repräsentativen Verwendungsmusters von jeder einer Klasse, welcher ein Verwendungsmuster vor der Änderung angehört, und einer Klasse, welcher ein Verwendungsmuster nach der Änderung angehört, wenn sich das Verwendungsmuster der Batterie ändert.

## Revendications

1. Appareil de prédiction de durée de vie de batterie (10) comprenant :
une unité de génération de données (110) configurée pour générer des données de durée de vie restante correspondant à chacune d'une pluralité d'informations de profils d'utilisation concernant une batterie ; et
une unité de prédiction de durée de vie de batterie (130) configurée pour classer une pluralité de profils d'utilisation dans au moins une classe en utilisant un modèle de réseau neuronal artificiel entraîné (120), déterminer un profil d'utilisation représentatif parmi des profils d'utilisation appartenant à chaque classe, et prédire une durée de vie de la batterie sur la base de données de durée de vie restante correspondant au profil d'utilisation représentatif.

2. Appareil de prédiction de durée de vie de batterie selon la revendication 1, comprenant en outre une unité d'entraînement de modèle de réseau neuronal artificiel configurée pour entraîner le modèle de réseau neuronal artificiel à classer un profil d'utilisation d'entrée dans l'au moins une classe.

3. Appareil de prédiction de durée de vie de batterie selon la revendication 2, dans lequel le modèle de réseau neuronal artificiel calcule une similarité entre le profil d'utilisation d'entrée et le profil d'utilisation représentatif et détermine une classe du profil d'utilisation sur la base de la similarité.

4. Appareil de prédiction de durée de vie de batterie selon la revendication 3, dans lequel le modèle de réseau neuronal artificiel calcule la similarité sur la base d'un taux de réduction de durée de vie de batterie de chacun du profil d'utilisation d'entrée et du profil d'utilisation représentatif dans une période spécifique.

5. Appareil de prédiction de durée de vie de batterie selon la revendication 1, dans lequel l'unité de prédiction de durée de vie de batterie est en outre configurée pour déterminer, en tant que profil d'utilisation représentatif, un profil d'utilisation qui a le plus grand impact sur une durée de vie restante de la batterie, parmi une pluralité de profils d'utilisation appartenant à chaque classe.

6. Appareil de prédiction de durée de vie de batterie selon la revendication 5, dans lequel l'unité de prédiction de durée de vie de batterie est en outre configurée pour prédire la durée de vie de la batterie sur la base des données de durée de vie restante correspondant à un profil d'utilisation représentatif d'une classe à laquelle un profil d'utilisation réel de la batterie appartient, au lieu de données de durée de vie restante correspondant au profil d'utilisation réel.

7. Appareil de prédiction de durée de vie de batterie selon la revendication 6, dans lequel l'unité de prédiction de durée de vie de batterie est en outre configurée pour convertir des premières données indiquant une durée de vie restante du profil d'utilisation représentatif par rapport à un temps d'utilisation en secondes données indiquant un temps nécessaire pour atteindre la durée de vie restante, et pour calculer une durée de vie restante par rapport à un changement du profil d'utilisation de la batterie sur la base de secondes données d'un profil d'utilisation représentatif de chacune d'une classe à laquelle un profil d'utilisation avant le changement appartient et d'une classe à laquelle un profil d'utilisation après le changement appartient lorsque le profil d'utilisation de la batterie change.

8. Appareil de prédiction de durée de vie de batterie selon la revendication 1, dans lequel les informations de profil d'utilisation comprennent au moins un parmi une énergie de décharge accumulée, un état de charge (SoC), une profondeur de décharge (DoD), une capacité C et une capacité CP de la batterie.

9. Procédé de fonctionnement d'un appareil de prédiction de durée de vie de batterie, le procédé de fonctionnement comprenant :
la génération (S610) de données de durée de vie restante correspondant à chacune d'une pluralité d'informations de profil d'utilisation concernant une batterie ;
la classification (S630) d'une pluralité de profils d'utilisation dans au moins une classe en utilisant un modèle de réseau neuronal artificiel entraîné (S620) ;
la détermination (S640) d'un profil d'utilisation représentatif parmi des profils d'utilisation appartenant à chaque classe ; et
la prédiction (S650) d'une durée de vie de la batterie sur la base de données de durée de vie restante correspondant au profil d'utilisation représentatif.

10. Procédé de fonctionnement selon la revendication 9, comprenant en outre l'entraînement du modèle de réseau neuronal artificiel pour classer un profil d'utilisation d'entrée dans l'au moins une classe.

11. Procédé de fonctionnement selon la revendication 10, dans lequel le modèle de réseau neuronal artificiel calcule une similarité entre le profil d'utilisation d'entrée et le profil d'utilisation représentatif et détermine une classe du profil d'utilisation sur la base de la similarité.

12. Procédé de fonctionnement selon la revendication 11, dans lequel le modèle de réseau neuronal artificiel calcule la similarité sur la base d'un taux de réduction de durée de vie de batterie de chacun du profil d'utilisation d'entrée et du profil d'utilisation représentatif dans une période spécifique.

13. Procédé de fonctionnement selon la revendication 9, dans lequel la détermination du profil d'utilisation représentatif comprend la détermination, en tant que profil d'utilisation représentatif, d'un profil d'utilisation qui a le plus grand impact sur une durée de vie restante de la batterie, parmi une pluralité de profils d'utilisation appartenant à chaque classe.

14. Procédé de fonctionnement selon la revendication 13, dans lequel la prédiction de la durée de vie de la batterie comprend la prédiction de la durée de vie de la batterie sur la base des données de durée de vie restante correspondant à un profil d'utilisation représentatif d'une classe à laquelle un profil d'utilisation réel de la batterie appartient, au lieu de données de durée de vie restante correspondant au profil d'utilisation réel.

15. Procédé de fonctionnement selon la revendication 13, dans lequel la prédiction de la durée de vie de la batterie comprend :
la conversion de premières données indiquant une durée de vie restante du profil d'utilisation représentatif par rapport à un temps d'utilisation en secondes données indiquant un temps nécessaire pour atteindre la durée de vie restante ; et
le calcul d'une durée de vie restante par rapport à un changement du profil d'utilisation de la batterie sur la base de secondes données d'un profil d'utilisation représentatif de chacune d'une classe à laquelle un profil d'utilisation avant le changement appartient et d'une classe à laquelle un profil d'utilisation après le changement appartient lorsque le profil d'utilisation de la batterie change.
